# FASCICULE DE BREVET EUROPEEN

(11) **EP 2 965 101 B1**
(45) Date de publication et mention de la délivrance du brevet: **12.04.2017**
(21) Numéro de dépôt: 14718644.9
(22) Date de dépôt: 04.03.2014
(51) Int. Cl.: G01R 31/34, H02K 15/16, H02P 29/032

(54) **PROCÉDÉ DE DÉTECTION D'UN DÉFAUT D'EXCENTRICITÉ D'UN ROTOR D'UNE MACHINE ÉLECTRIQUE TOURNANTE**
VERFAHREN ZUR FEHLERERFASSUNG IN DER EXZENTRIZITÄT EINES ROTORS EINER ROTIERENDEN ELEKTRISCHEN MASCHINE
METHOD FOR DETECTING A FAULT IN THE ECCENTRICITY OF A ROTOR OF A ROTATING ELECTRICAL MACHINE

(30) Priorité: 05.03.2013 FR 1351977
(43) Date de publication de la demande: 13.01.2016
(73) Titulaire: Electricité de France, 75008 Paris (FR)
(72) Inventeur: JACQ, Thierry, 93170 Bagnolet (FR); GUILLOT, Eilin, 91420 Morangis (FR); BIET, Mélisande, 92130 Issy Les Moulineaux (FR); DE CHILLAZ, Antoine, 92130 Issy Les Moulineaux (FR); CHARBONNIER, Bruno, 75011 Paris (FR)
(74) Mandataire: Cabinet Plasseraud
(86) Numéro de dépôt international: PCT/FR2014/050475
(87) Numéro de publication internationale: WO 2014/135784

(56) Documents cités:
- EP-A1- 1 455 436
- EP-A1- 1 464 974
- DE-B- 1 226 200
- JP-A- 2006 280 158
- KR-B1- 101 210 825
- US-A- 3 506 914
- US-A1- 2013 033 215
- NANDI S ET AL: "Condition monitoring and fault diagnosis of electrical machines-a review", CONFERENCE RECORD OF THE 1999 IEEE INDUSTRY APPLICATIONS CONFERENCE. THIRTY-FORTH IAS ANNUAL MEETING (CAT. NO.99CH36370), IEEE, IEEE PISCATAWAY, NJ, USA, vol. 1, 3 octobre 1999 (1999-10-03), pages 197-204, XP010355174, DOI: 10.1109/IAS.1999.799956 ISBN: 978-0-7803-5589-7
- EBRAHIMI B M ET AL: "Magnetic field and vibration monitoring in permanent magnet synchronous motors under eccentricity fault", IET ELECTRIC POWER APPLICATIONS, IET, UK, vol. 6, no. 1, 10 janvier 2012 (2012-01-10), pages 35-45, XP006041275, ISSN: 1751-8660, DOI: 10.1049/IET-EPA.2010.0159
- SHNIBHA R A ET AL: "Smart Technique for Induction Motors Diagnosis by Monitoring the Power Factor Using Only the Measured Current", JOURNAL OF PHYSICS: CONFERENCE SERIES, INSTITUTE OF PHYSICS PUBLISHING, BRISTOL, GB, vol. 364, no. 1, 28 mai 2012 (2012-05-28), page 12062, XP020223144, ISSN: 1742-6596, DOI: 10.1088/1742-6596/364/1/012062
- GUILLERMO A JIMÉNEZ ET AL: "Fault detection in induction motors using Hilbert and Wavelet transforms", ELECTRICAL ENGINEERING ; ARCHIV FÜR ELEKTROTECHNIK, SPRINGER, BERLIN, DE, vol. 89, no. 3, 24 février 2006 (2006-02-24), pages 205-220, XP019457881, ISSN: 1432-0487

## Description

La présente invention se rapporte à un procédé de détection d'un défaut d'excentricité d'un rotor d'une machine électrique tournante telle qu'un alternateur, utilisant des mesures de flux électromagnétique réalisées par une sonde disposée dans un entrefer de la machine électrique, et réalisant l'échantillonnage d'un signal de sonde mesuré par la sonde sur au moins un tour du rotor.

Une excentricité dynamique d'un rotor se traduit par le fait que l'axe central du rotor tourne d'une manière décalée par rapport à l'axe central du stator, alors que dans le cas d'une machine électrique tournante idéale l'axe du rotor coïncide en permanence avec l'axe du stator. Par conséquent, en tout point de l'entrefer, l'excentricité dynamique se traduit par le fait que l'épaisseur de l'entrefer varie pendant la rotation du rotor. Le rotor subit alors une force d'attraction déséquilibrée qui tourne avec lui, ce qui peut provoquer un bruit acoustique et des vibrations de l'arbre du rotor.

L'excentricité dynamique se conjugue souvent à une excentricité statique. En effet, dans le cas d'une excentricité statique initialement sans excentricité dynamique, le rotor tourne autour de son axe central, mais ce dernier est décalé de manière fixe par rapport à l'axe central du stator. Ce décalage peut résulter par exemple d'un mauvais positionnement du rotor ou du stator à l'assemblage de la machine, et génère une attraction magnétique constante vers le stator. Cette attraction magnétique tend à déformer l'arbre du rotor, ce qui diminue encore localement l'épaisseur de l'entrefer et augmente par conséquent la force d'attraction magnétique. L'accentuation du phénomène tend à dégrader les paliers de l'arbre du rotor et à entraîner l'apparition d'une excentricité dynamique.

Une excentricité dynamique d'un rotor peut être détectée par des mesures du flux dans l'entrefer de la machine. Dans le but généralement de suivre l'état diélectrique des bobinages dans les rotors des machines synchrones d'un parc de centrales nucléaires ou de centrales thermiques, de nombreux exploitants dont la demanderesse ont installé des sondes comprenant des capteurs de flux dans l'entrefer des machines. Depuis quelques années, les turbo-alternateurs du parc nucléaire de la demanderesse sont équipés chacun d'une telle sonde, qui a généralement été installée à l'occasion de la mise à l'arrêt de la machine pour son inspection générale une fois tous les dix ans. Une sonde comprend dans la plupart des cas deux bobines de détection de flux. Un modèle de sondes peut posséder une bobine radiale et une bobine tangentielle, ou plus rarement deux bobines radiales dont l'une est en secours de l'autre en cas de défaillance telle qu'une rupture de la bobine. Le risque de défaillance d'une bobine est cependant extrêmement faible, par conséquent les sondes à bobines radiale et tangentielle sont préférées par la demanderesse.

Typiquement, une bobine radiale et une bobine tangentielle d'une même sonde de flux sont disposées l'une à côté de l'autre à l'extrémité d'un boitier formé par une canule qui traverse le stator dans une direction radiale. La bobine radiale, sensible au flux radial, est orientée selon l'axe de la canule, tandis que la bobine tangentielle est orientée perpendiculairement à l'axe de la canule et dans un plan radial contenant l'axe du rotor pour être sensible au flux tangentiel. Un exemple de disposition des deux bobines radiale et tangentielle d'une sonde de flux est décrit dans le brevet américain US3506914. Lorsque la machine est en fonctionnement, les variations du champ magnétique dans l'entrefer engendrent une force électromotrice aux bornes de chacune des deux bobines. La tension aux bornes de chaque bobine peut être mesurée sur une durée correspondant à au moins un tour du rotor.

Comme expliqué dans le brevet américain US3506914, le signal mesuré par une sonde de flux peut être traité afin de rechercher d'éventuels indices révélateurs de la présence d'un court-circuit dans le bobinage du rotor. Un avantage d'une telle technique est de permettre un diagnostic en ligne, c'est-à-dire avec la machine en fonctionnement et sans perturber le fonctionnement. Néanmoins, la recherche d'un éventuel défaut d'excentricité dynamique et/ou statique du rotor n'est pas abordée par la méthode de détection décrite dans ce brevet. De nombreuses méthodes connues pour diagnostiquer les défauts d'excentricité utilisent des capteurs capacitifs pour mesurer l'entrefer de la machine en plusieurs endroits du pourtour interne du stator. Plus rarement, d'autres méthodes utilisent les mesures de plusieurs sondes de flux décalées angulairement dans l'entrefer de la machine. Les signaux mesurés par les différentes sondes de flux sont traités par une analyse spectrale, par exemple selon le principe de la transformée de Fourier rapide (FFT), afin d'étudier différentes raies d'harmoniques générées par l'analyse spectrale. L'étude des raies d'harmoniques permet généralement la détection de plusieurs types de défauts d'excentricité du rotor, en particulier les défauts d'excentricité dynamique et les défauts d'excentricité statique.

Une méthode de détection de l'excentricité d'une machine synchrone par une telle analyse spectrale est décrite dans la publication de la demande de brevet européen EP1455436A1. Le dispositif de détection décrit dans ce document utilise des capteurs de flux constitués par des spires de mesure individuelles réparties le long de la périphérie du stator entre des fentes de ventilation de la couronne statorique dentée, cf. Fig.6 du document. Ces capteurs mesurent donc en ligne le flux de la couronne statorique selon différentes positions angulaires. Un traitement particulier des signaux mesurés permet de détecter et de quantifier les excentricités dynamique et statique de la machine. Le procédé de détection décrit dans ce document de brevet EP1455436A1 présente néanmoins des inconvénients. En particulier, la plupart des alternateurs en service dans le parc au moins européen de centrales thermiques ou nucléaires ne sont pas équipés de telles spires de mesure dont la mise en place est relativement délicate et requiert un arrêt de la machine.

Le document US 2013/033215 A1 divulgue également un procédé de détection d'un défaut d'excentricité d'un rotor d'une machine électrique tournante utilisant des mesures de flux électromagnétique réalisées par une sonde disposée dans un entrefer de la machine, et réalisant l'échantillonnage d'un signal de sonde mesuré par la sonde sur au moins un tour du rotor.

La présente invention vise à proposer un procédé de détection de l'excentricité dynamique d'une machine tournante, procurant des résultats fiables à partir du traitement des signaux d'une sonde de flux d'entrefer installée sur la machine, et vise notamment à permettre que la sensibilité de la détection s'adapte automatiquement à la machine à surveiller.

A cet effet, l'invention a pour objet un procédé de détection tel que défini en introduction, caractérisé en ce que qu'il comprend les étapes suivantes :
- l'identification d'un tronçon entier de la mesure du signal de sonde et son découpage en plusieurs tronçons polaires de même longueur chacun, ledit tronçon entier correspondant à un tour complet du rotor, la longueur d'un dit tronçon polaire étant déterminée comme la longueur dudit tronçon entier divisée par le nombre de pôles du rotor ;
- la génération d'au moins un signal de différence représentatif de la différence point par point entre les mesures du signal de sonde relatives à deux tronçons polaires ;
- le calcul d'un écart type dudit signal de différence ;
- pour chaque paire de deux tronçons polaires correspondant à un signal de différence, la détermination d'une valeur positive d'extremum prenant en compte au moins un extremum des mesures du signal de sonde sur les deux tronçons polaires ;
- le calcul d'un indicateur d'excentricité pour chaque signal de différence, prenant en compte ledit écart type du signal de différence ainsi que ladite valeur positive d'extremum ; et
- le signalement d'un défaut d'excentricité dynamique dès lors qu'au moins un dit indicateur d'excentricité dépasse une valeur de seuil d'indicateur prédéterminée.

Grâce à ces dispositions, et du fait notamment que l'indicateur d'excentricité de chaque signal de différence prend en compte une valeur d'extremum du signal de sonde, il n'est pas nécessaire d'adapter spécialement le traitement des mesures du signal de sonde à la machine particulière sur laquelle le procédé de détection est mis en oeuvre. En particulier, la valeur prédéterminée du seuil d'indicateur ne nécessite pas spécialement d'être modifiée d'une machine à une autre. En outre, bien que le facteur de charge de la machine ait une influence conjointe à la fois sur l'amplitude (et donc sur l'écart type) de chaque signal de différence, et sur les valeurs des extrema du signal de sonde, le calcul de l'indicateur d'excentricité peut être prévu de façon à ce que le résultat soit relativement peu sensible aux possibles variations du facteur de charge pendant la durée de la mesure. Par exemple, l'indicateur d'excentricité peut être calculé comme un ratio entre l'écart type d'un signal de différence et une valeur d'extremum du signal de sonde, qui sont deux grandeurs qui augmentent ensemble en cas d'augmentation du facteur de charge. La comparaison entre l'indicateur d'excentricité et le seuil d'indicateur est donc peu affectée en pratique par les variations du facteur de charge, a fortiori si la durée de la mesure traitée ne dépasse pas 1,25 tours, ce qui permet avec une mesure de qualité qu'un défaut d'excentricité dynamique réel se traduise quasi systématiquement par le dépassement du seuil d'indicateur par au moins un indicateur d'excentricité.

Dans des modes de réalisation préférés d'un procédé de détection selon l'invention, on a recours notamment à l'une ou l'autre des dispositions suivantes : ladite valeur positive d'extremum du signal de sonde pour une paire de tronçons polaires est déterminée comme égale au maximum de la valeur absolue des mesures du signal de sonde sur les deux tronçons polaires ;
l'indicateur d'excentricité est calculé comme le ratio entre ledit écart type du signal de différence et ladite valeur positive d'extremum ;
ladite valeur de seuil d'indicateur est comprise entre 0,030 et 0,040, et est préférablement égale à 0, 035 ;
ledit signal de sonde est enregistré sur un nombre de tours du rotor compris entre 1,25 et 2,5 ;
la fréquence d'échantillonnage du signal de sonde est au moins égale à 50 KHz, et l'échantillonnage utilise un convertisseur analogique/numérique ayant une résolution d'au moins 12 bits ;
si un signal de top-tour est disponible on identifie dans le signal de sonde chaque instant correspondant à un top-tour ; et si un signal de top-tour n'est pas disponible, on construit ce signal par auto-corrélation des mesures du signal de sonde effectuées sur au moins 1,25 tours, en connaissance de la fréquence théorique du réseau et du nombre de paires de pôles de la machine électrique, le top-tour étant identifié par les maxima de corrélation ;
on identifie un dit tronçon entier du signal de sonde comme la mesure du signal sur une période entre deux top-tours consécutifs, et on procède à un ré-échantillonnage du signal afin que chaque tronçon entier ait la même longueur en terme de nombre de points de mesure que la longueur théorique d'un tour sur la base de la fréquence théorique du réseau ;
on génère un nombre Ns de signaux de différence, Ns vérifiant la relation Ns = Np - 1 où Np est le nombre de pôles de la machine électrique, et dans lequel un défaut d'excentricité est signalé dès lors que l'indicateur d'excentricité d'au moins un signal de différence dépasse le seuil d'indicateur ;
deux tronçons polaires consécutifs sont comparés entre eux pour générer un dit signal de différence.

D'autres caractéristiques et avantages ressortent de la description qui va suivre d'exemples non limitatifs de modes de réalisation, en référence aux figures dans lesquelles :
La FIG.1 représente un exemple du signal de la tension issue d'une bobine d'une sonde de flux d'entrefer ;
La FIG.2 représente un autre exemple d'un signal fourni par une sonde de flux, et illustre le marquage d'un signal de top-tour et le découpage d'un tour en quatre tronçons polaires ;
La FIG.3 représente la superposition des signaux des deux premiers tronçons polaires du signal de sonde de la FIG.2, avec un agrandissement d'une zone de points où des écarts entre les deux signaux apparaissent ;
La FIG.4 représente un exemple de superposition de signaux de tronçons polaires d'un signal de sonde, dans lequel des écarts entre les signaux laissent suspecter la présence d'un défaut d'excentricité dynamique ;
La FIG.5 représente des signaux de différence pôle à pôle générés par des comparaisons des signaux superposés de la FIG.4 ;

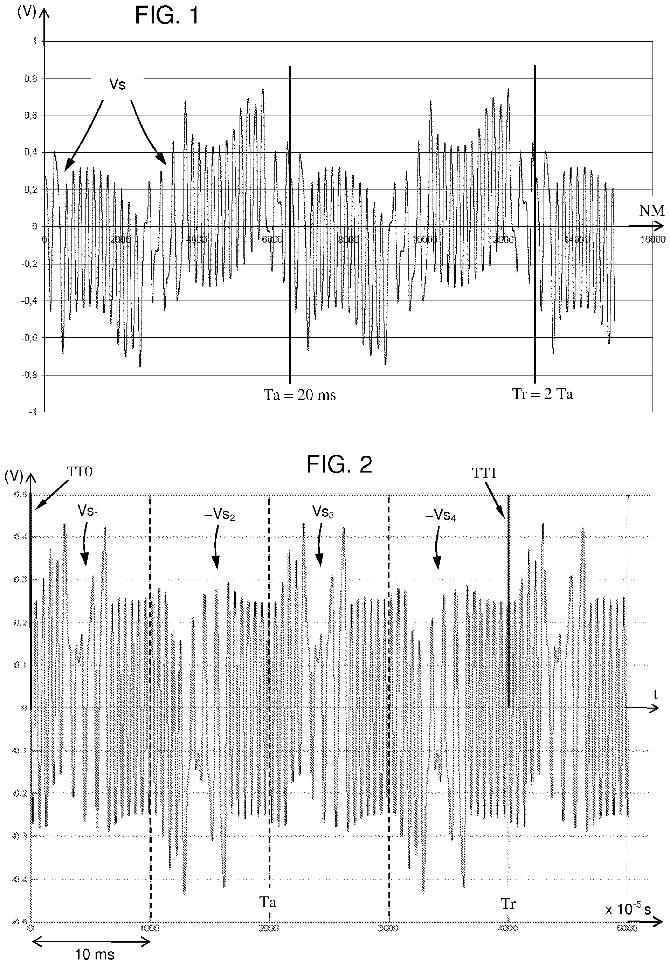

Sur la FIG.1 est représenté un exemple d'une mesure échantillonnée du signal Vs de la tension issue d'une des deux bobines d'une sonde de flux d'entrefer, la mesure étant effectuée pendant 1,25 tour du rotor de l'alternateur. Une telle mesure de sonde de flux peut être relevée par exemple automatiquement entre une fois toutes les 5 minutes et une fois toutes les 24 heures. La graduation en abscisse correspond au nombre NM de points de mesure générés par l'échantillonnage du signal de la sonde. L'instant initial de la mesure, ainsi que l'angle initial du rotor, sont quelconques. Le signal présente une allure périodique de période apparente Ta, chaque période apparente couvrant une succession de deux trains d'impulsions qui apparaissent inversés l'un par rapport à l'autre. Chaque train d'impulsions correspond aux variations du flux magnétique dans l'entrefer lors du passage des encoches d'un pôle devant la sonde. Le rotor possédant quatre pôles, la période apparente Ta correspond à un demi-tour du rotor et est égale à 20 ms si la fréquence du réseau est égale à 50 Hz. Un tour complet du rotor s'effectue sur une période Tr égale au double de la période apparente Ta.

Dans le cas où tous les pôles sont sains, les trains d'impulsions des pôles pairs et ceux des pôles impairs sont en théorie identiques, et chaque train d'impulsions d'un pôle pair est exactement l'inverse d'un train d'impulsions d'un pôle impair. Sur une machine réelle, il existe une différence minime entre les flux magnétiques générés par les pôles successifs du rotor. De plus, le bruit de la mesure crée également des différences entre les flux magnétiques mesurés sur des pôles successifs. Par conséquent, les trains d'impulsions successifs ne sont pas rigoureusement identiques entre eux. La comparaison entre le signal d'un train d'impulsions et le signal d'un autre train d'impulsions, par superposition des deux trains d'impulsions redressés dans le même sens et par soustraction point à point des valeurs des deux signaux, ne donne donc pas un signal de différence parfaitement nul même avec des pôles sains.

Concernant la comparaison pôle à pôle, on utilise dans la présente le terme pôle pour désigner un tronçon du signal de sonde correspondant à un quart de tour du rotor pour un rotor comprenant quatre pôles, ou à un demi tour du rotor pour un rotor comprenant deux pôles. Ce pôle ne se superpose pas nécessairement à un pôle au sens électrotechnique. En effet, on désigne par tronçon entier un tronçon du signal de sonde correspondant à un tour complet du rotor. Comme expliqué plus loin, l'instant initial de la mesure d'un tronçon entier ne correspond pas nécessairement à la séparation entre deux pôles au sens électrotechnique. On divise un tronçon entier par le nombre de pôles du rotor pour former des tronçons de signal de même longueur désignés comme tronçons polaires. Ainsi, lorsqu'on parle de comparaison pôle à pôle du signal, il s'agit de comparer les mesures respectives du signal de deux tronçons polaires distincts.

Afin de ne pas fausser la comparaison pôle à pôle du signal de la sonde de flux, il convient de recaler au mieux les différents tronçons polaires correspondant aux pôles, de façon à ce que deux points comparés entre deux tronçons polaires représentent la comparaison des mesures du flux à des positions angulaires du rotor qui correspondent exactement l'une à l'autre sur les deux pôles comparés. Un recalage imparfait entre les tronçons polaires augmente artificiellement les différences point à point dans la comparaison pôle à pôle, ce qui entraîne généralement un fort écart-type du signal de différence et empêche souvent de distinguer un écart-type révélateur d'un défaut.

Afin de permettre un bon recalage entre les tronçons polaires, il faut identifier précisément sur le signal de sonde le point de top-tour correspondant exactement à un tour du rotor, afin d'identifier un tronçon entier dont la longueur correspond exactement à un tour. Un signal de top-tour peut être disponible ou non, selon le matériel de mesure équipant la machine tournante. Par exemple, le signal de top-tour pourra être fourni par un capteur prévu à cet effet et être utilisé s'il est suffisamment précis. En l'absence d'un tel signal de top-tour disponible, il faut le construire à partir du signal de sonde. La connaissance de la fréquence d'échantillonnage du signal de sonde et du nombre de paires de pôles de la machine permet de calculer la longueur théorique d'un tour.

Si la fréquence d'échantillonnage n'est pas connue, son estimation repose sur le fait qu'un alternateur tourne à une vitesse connue, par conséquent il existe une périodicité du signal de sonde de flux comme montré en référence à la FIG.1. Avec une fréquence du réseau de 50 Hz, une paire de pôles est vue par la sonde de flux toutes les 20 ms. En corrélant le signal avec lui-même, le premier maximum de corrélation correspond donc à une période de 20 ms. Il suffit de trouver la localisation en nombre de points de ce premier maximum et de la diviser par 20 pour obtenir la fréquence d'échantillonnage en kHz. Cette méthode permet d'exploiter les signaux en l'absence de l'information sur la fréquence d'acquisition. Cependant elle repose sur la valeur moyenne de 20 ms pour la période du réseau, or la fréquence du réseau est susceptible de varier autour de 50 Hz. Il est donc préférable de connaître a priori la fréquence d'échantillonnage de la sonde de flux. Par ailleurs, si la fréquence d'échantillonnage est inférieure à 100 kHz, une interpolation du signal peut être avantageusement réalisée pour recréer un échantillonnage à 100 kHz, ce qui permet d'avoir une précision temporelle suffisante pour la détection. L'interpolation retenue se fait dans le domaine spectral, par transformée de Fourier du signal, ajout de points (zéros au milieu) à la transformée, et transformée de Fourier inverse.

Avec le nombre p de paires de pôles, par exemple deux paires de pôles pour un alternateur d'une centrale nucléaire, ainsi que la fréquence d'échantillonnage Fe en Hz et la fréquence du réseau égale par exemple à 50 Hz, on calcule la longueur théorique d'un tour comme le nombre N de points échantillonnés sur la durée théorique d'un tour du rotor, par la relation suivante : N = Fe • p / 50. On enregistre le signal sur au moins le nombre N de points, et préférablement sur au moins 1,25 fois ce nombre N de points pour avoir une mesure sur au moins un tour un quart du rotor.

En effet, si l'enregistrement est limité au nombre N de points, c'est-à-dire à la longueur théorique d'un tour, il n'est pas certain en réalité qu'exactement un tour entier soit enregistré, du fait notamment des variations de la fréquence du réseau autour de 50 Hz. Par exemple, une fréquence du réseau égale à 50,5 Hz correspond à une durée de 19,8 ms pour un tour réel du rotor, soit un écart de 0,2 ms par rapport à la période de 20 ms correspondant à 50 Hz. Avec une fréquence d'échantillonnage par exemple égale à 100 kHz, cet écart de 0,2 ms correspond à 20 points de mesure en moins par rapport au nombre N de points. La corrélation du signal avec lui-même risque donc fort de ne présenter aucun maximum.

Une fois l'enregistrement réalisé sur au moins un tour un quart du rotor, on choisit une partie de l'enregistrement de longueur 1,25 fois le nombre N de points, puis on procède à l'auto-corrélation du signal et on recherche les maxima de cette corrélation autour des points théoriques de fin des tours. La localisation de ces maxima donne directement l'information correspondant au top-tour. On obtient en sortie un signal qui vaut 0 partout, sauf aux localisations des maxima de corrélation où il vaut 1. Il peut être préférable de réaliser l'enregistrement sur 2,5 tours du rotor, afin de pouvoir étudier plusieurs parties d'enregistrement chacune de longueur 1,25 fois le nombre N de points, ce qui permet ensuite de choisir une partie d'enregistrement pour laquelle l'auto-corrélation du signal présenterait éventuellement des maxima plus précis en comparaison avec une autre partie d'enregistrement.

Un exemple de marquage d'un signal de top-tour est représenté sur la FIG.2. Il s'agit dans cet exemple d'une mesure d'un signal de sonde de flux sur une machine différente de celle correspondant à la FIG.1 et dont le rotor possède également quatre pôles. L'amplitude maximale du signal est plus petite que dans l'exemple précédent. L'instant initial de la mesure ne correspond pas à la séparation entre deux pôles au sens électrotechnique, puisqu'il se situe ici aux alentours du milieu d'un train d'impulsions. La fréquence d'échantillonnage étant fixée à 100 kHz, le nombre théorique N de points sur un tour à compter de l'instant initial de la mesure est égal à 4000, puisque la période Tr de rotation du rotor est égale à 40 ms pour une fréquence du réseau égale à 50 Hz. Le point de top-tour TT1, qui correspond à un tour à compter du top-tour initial TT0 fixé sur le premier point de la mesure, peut être indiqué grâce à un capteur prévu à cet effet sur la machine, ou être trouvé par la méthode susmentionnée de repérage d'un maximum de corrélation. Ce point de top-tour TT1 ne se situe pas nécessairement exactement sur le point n° N correspondant à la durée théorique d'un tour. En effet, le point TT1 se situera généralement dans une plage de variation de quelques points autour du point n° N théorique du fait d'une variation minime de la fréquence du réseau autour de 50 Hz. Ainsi, du fait de la variation de la fréquence du réseau, une mesure du signal de sonde sur plusieurs tours fera généralement apparaître des tours de rotation réelle qui n'ont pas exactement la même longueur en terme de nombre de points de mesure entre deux points consécutifs de top-tours.

Afin de pouvoir effectuer une comparaison précise des pôles, il est important de ré-échantillonner l'enregistrement effectué du signal de sonde mesuré, afin que chaque tour découpé ait la même longueur en terme de nombre de points de mesure que la longueur d'un tour sur la base de la fréquence théorique du réseau. Par exemple, si le point de top-tour TT1 sur la FIG.2 se situe entre les points n° 3990 et n° 3999 de la mesure, le signal de sonde enregistré entre les deux points de top-tour TT0 et TT1 sera ré-échantillonné de façon à ce que le point de top-tour TT1 se situe exactement au point n° 4000 de la mesure. Si cette étape de ré-échantillonnage n'est pas effectuée, il apparaît généralement des décalages temporels dans la superposition des signaux des pôles, qui peuvent entraîner des différences pôle à pôle importantes. Ces différences faussent le calcul du signal de différence, surtout lors des fronts raides du signal de force électromotrice mesuré par la sonde.

Une fois que le signal a été découpé en au moins un tronçon entier correspondant à un tour comme décrit ci-dessus, un tronçon entier est divisé en tronçons polaires représentant chacun un pôle, en divisant la longueur du tronçon entier par le nombre de pôles du rotor. Dans l'exemple de la FIG.2, le rotor possédant quatre pôles, chaque pôle correspond à un tronçon de signal comprenant exactement 1000 points de mesures à une fréquence d'échantillonnage de 100 kHz, soit une durée de 10 ms par pôle. Une fois les pôles identifiés en tronçons polaires du signal de sonde, afin de pouvoir comparer les pôles deux à deux par superposition, il convient de changer le signe des signaux correspondants aux pôles pairs pour qu'ils soient dans le même sens que les pôles impairs. Par exemple, le deuxième pôle identifié, c'est-à-dire le deuxième tronçon polaire du signal de sonde, est désigné arbitrairement comme un pôle pair et correspond à un tronçon de signal -Vs₂ qui est quasiment l'inverse du tronçon de signal Vs₁ correspondant au premier tronçon polaire identifié. Le changement de signe du tronçon de signal -Vs₂ génère un tronçon de signal Vs₂ qui en théorie se superpose exactement au tronçon de signal Vs₁ pour une machine sans défaut. En d'autres termes, tous les pôles (tronçons polaires) se superposent exactement les uns sur les autres en théorie pour une machine sans défaut.

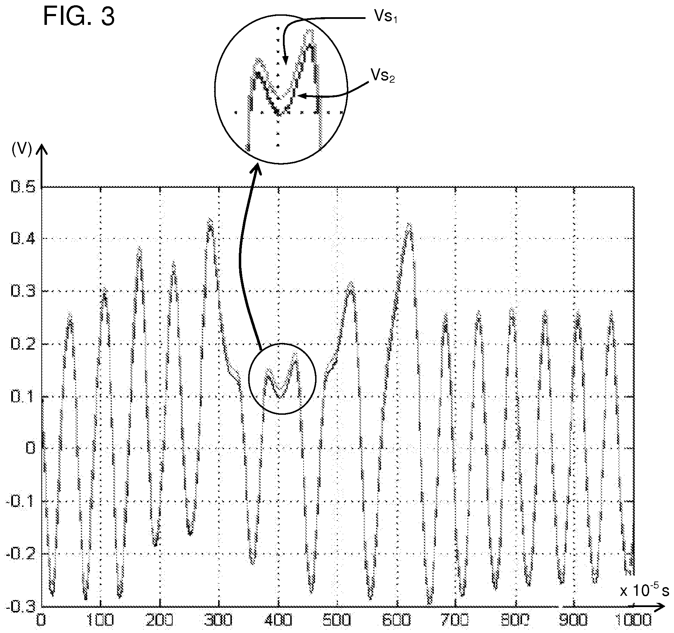

Sur la FIG.3, on a représenté la superposition des tronçons de signaux Vs₁ et Vs₂ correspondant aux deux premiers tronçons polaires. Les pôles physiques du rotor sont sains, néanmoins la superposition des tronçons polaires fait apparaître des différences minimes entre les deux signaux, principalement aux extrema des oscillations des signaux. Comme expliqué précédemment, le signal de différence obtenu par soustraction point à point des valeurs des deux signaux superposés n'est donc pas parfaitement nul même avec des pôles sains. Dans l'exemple représenté, on peut déduire que le signal de différence atteint un maximum de l'ordre de 0,02 V dans une zone autour du point de mesure n° 400.

Dans le cas d'un défaut d'excentricité dynamique, y compris si ce défaut se conjugue à une excentricité statique, la paire de pôles dont les deux signaux de sonde présentent les plus grands écarts de superposition, c'est-à-dire pour laquelle le signal de différence correspondant à une comparaison pôle à pôle présente le plus grand écart type, n'est pas connue a priori. Dans le cas d'un rotor comportant au moins deux paires de pôles, afin qu'au moins un signal de différence traduise le défaut, il est préférable de générer plusieurs signaux de différence dans lesquels aucun pôle n'est oublié. Une façon de générer les signaux de différence consiste à effectuer la différence entre le signal d'un tronçon polaire et le signal du tronçon polaire consécutif après son inversion, ce qui revient à effectuer une série de comparaisons entre pôles consécutifs. Puisque le signal est inversé entre un pôle pair et un pôle impair, la génération d'un signal de différence entre deux pôles consécutifs peut s'effectuer en additionnant point à point les valeurs algébriques des points de mesures de deux tronçons polaires consécutifs. Par exemple, le signal de différence (en l'occurrence Vs₁ -Vs₂) entre les deux premiers pôles consécutifs peut être calculé en additionnant les signaux (Vs₁ et -Vs₂) des deux premiers tronçons polaires.

De manière générale, le nombre Ns de signaux de différence à générer vérifie la relation Ns = Np - 1, où Np est le nombre de pôles de la machine électrique. Dans le cas d'un rotor à deux pôles, comme c'est généralement le cas pour des alternateurs de centrales thermiques, puisqu'il n'y a que deux pôles à comparer entre eux, un seul signal de différence peut être généré. Dans le cas d'un rotor à quatre pôles, à titre d'exemple, on pourra comparer entre eux les tronçons polaires des paires de tronçons polaires suivants : n°1 et n°2, n°2 et n°3, n°3 et n°4. Il n'est néanmoins pas exclu de générer un nombre de signaux de différence supérieur à Np - 1, mais cela n'est généralement pas nécessaire. Par exemple, on pourrait comparer également les tronçons polaires n°4 et n°1, de façon à avoir quatre signaux de différence. A l'inverse, il n'est pas non plus exclu de générer seulement deux signaux de différence voire un seul signal de différence.

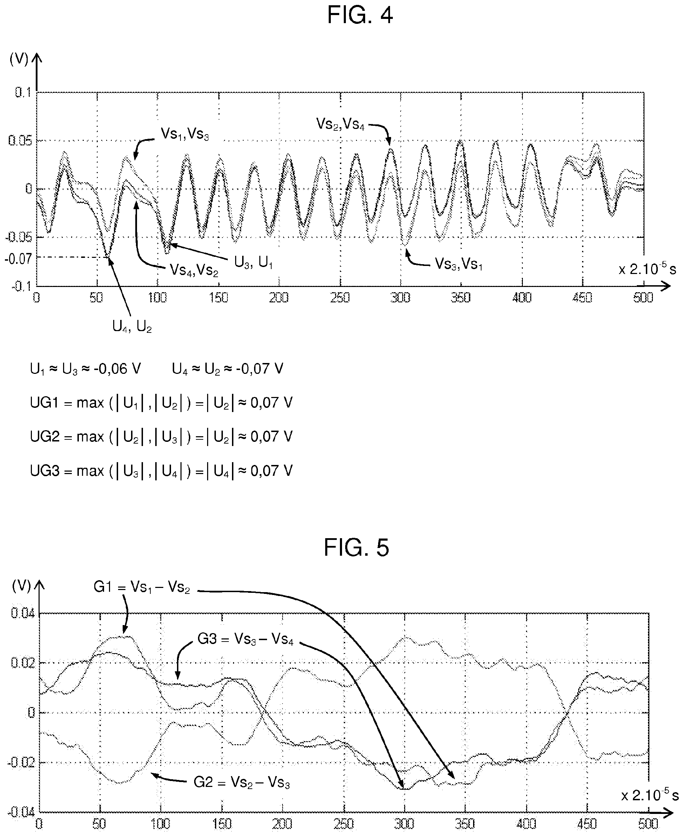

Sur la FIG.4, on a représenté la superposition des signaux Vs₁, Vs₂, Vs₃ et Vs₄ correspondant à quatre tronçons polaires d'un signal de sonde découpé en un tour comme décrit ci-dessus. La fréquence d'échantillonnage est égale à 50 kHz, ce qui donne un pas d'échantillonnage égal à 2•10⁻⁵ s. Un tronçon polaire correspond à une durée de 10 ms puisque la fréquence du réseau est égale à 50 Hz, et représente donc 500 points de mesure à la fréquence d'échantillonnage de 50 kHz. Comme visible sur la figure, les signaux des tronçons polaires sont mal superposés sur quasiment toute la longueur d'un tronçon polaire, ce qui le plus souvent est caractéristique d'un défaut d'excentricité dynamique. En particulier, les signaux Vs₁ et Vs₃ sont assez proches l'un de l'autre mais présentent chacun un écart généralement important avec les signaux Vs₂ et Vs₄ qui sont également assez proches l'un de l'autre. Par conséquent en observant un tel écart dans la superposition des tronçons polaires, la présence d'un défaut d'excentricité dynamique est très fortement suspectée.

Pour diagnostiquer la présence d'un défaut d'excentricité dynamique, on génère au moins un signal de différence Gi représentatif de la différence point par point entre les mesures relatives à deux tronçons polaires. Comme représenté sur la FIG.5, trois signaux de différence G1, G2 et G3 correspondant chacun à la différence entre deux tronçons polaires consécutifs sont calculés. Pour chaque paire de deux tronçons polaires correspondant à un signal de différence Gi, une valeur positive d'extremum UGi est déterminée à partir des signaux des tronçons polaires représentés sur la FIG.4, en prenant en compte au moins un extremum Uᵢ des signaux sur les deux tronçons polaires de la paire. Par exemple, pour le signal de différence G1 calculé comme la différence en valeur algébrique entre les signaux Vs₁ et Vs₂, on recherche sur le signal Vs₁ ainsi que sur le signal Vs₂ l'extremum ayant la plus grande valeur absolue. Le signal Vs₁ montre un extremum U₁ valant environ -0,06 V, tandis que Le signal Vs₂ montre un extremum U₂ valant environ -0,07 V. De ces deux extrema, la plus grande valeur absolue, soit 0,07 V, est retenue comme valeur positive d'extremum UG1 afin de procéder au calcul d'un indicateur d'excentricité E1 relatif au signal de différence G1.

Un indicateur d'excentricité Ei se calcule préférablement comme le ratio entre l'écart type e du signal de différence Gi et la valeur positive d'extremum UGi de la paire de tronçons polaires concernés. Par exemple, à supposer que pour le signal de différence G1, le calcul de l'écart type e1 donne pour résultat 0,02 V, l'indicateur d'excentricité E1 est égal à 0,02/0,07, soit environ 0,29. Dans l'exemple représenté, le calcul de l'écart type de chaque signal de différence donne pour résultat des valeurs très proches égales à environ 0,02 V. De plus, comme indiqué sur la FIG.5, la valeur positive d'extremum UGi pour chaque paire de deux tronçons polaires correspondant à un signal de différence Gi est égale à environ 0,07 V. Ainsi, chaque indicateur d'excentricité E1, E2 et E3 est égal à environ 0,290 dans cet exemple.

Pour diagnostiquer et donc pour signaler le défaut d'excentricité dynamique, chaque indicateur d'excentricité est comparé à une valeur de seuil d'indicateur S prédéterminée. Avec la méthode expliquée dans ce qui précède pour calculer l'indicateur d'excentricité, des expérimentations effectuées par la demanderesse ont abouti à choisir une valeur de seuil d'indicateur S comprise entre 0,030 et 0,040, et préférablement égale à 0,035. Dans l'exemple étudié, les indicateurs d'excentricité étant égaux à environ 0,290, le seuil d'indicateur S est très largement dépassé pour chaque signal de différence. Il n'y a donc aucun doute dans ce cas sur la présence d'un réel défaut d'excentricité dynamique. Les mesures effectuées par la demanderesse sur un parc d'alternateurs ont montré que les quelques cas pour lesquels le procédé de détection a identifié un réel défaut d'excentricité dynamique correspondent à des indicateurs d'excentricité supérieurs à 0,2. Néanmoins, un cas tangent pour lequel un léger défaut d'excentricité dynamique semble avéré a été identifié avec un indicateur d'excentricité égal à 0,042 concernant un signal de différence. Il est donc prudent d'après cette expérience de fixer le seuil d'indicateur S à une valeur inférieure ou égale à 0,040, mais ceci n'exclut pas de choisir une valeur plus élevée.

Une valeur de seuil d'indicateur S comprise entre 0,030 et 0,040 constitue un bon compromis pour détecter de façon quasiment certaine un défaut d'excentricité dynamique réel, et pour ne générer que peu de fausses alarmes. Les fausses alarmes recensées correspondent généralement à des cas où la qualité de la mesure du signal de sonde est insuffisante. En particulier, un signal de sonde insuffisamment quantifié augmente l'écart type de chaque signal de différence et conduit donc à un indicateur d'excentricité trop élevé qui peut dépasser la valeur de seuil d'indicateur même en l'absence de réel défaut d'excentricité dynamique. Un bruit de mesure élevé a également les mêmes conséquences.

La même valeur prédéterminée S peut être conservée d'une machine à une autre, sans compromettre la finesse de la détection. Il est par conséquent possible de réaliser un appareillage d'acquisition et de traitement des signaux d'une sonde de flux d'entrefer d'une machine électrique qui peut être déplacé d'une machine à une autre sans nécessiter une adaptation particulière de l'appareillage à la machine, pour détecter un défaut d'excentricité dynamique.

De manière générale, pour une bonne qualité de la mesure du signal de sonde, il est souhaitable que la fréquence d'échantillonnage du signal soit au moins égale à 50 KHz, et que l'échantillonnage utilise un convertisseur analogique/numérique ayant une résolution d'au moins 12 bits. En outre, il convient de régler le gain correctement de façon à explorer au maximum la plage de quantification, en évitant bien sûr les saturations. Par ailleurs, dans la plupart des cas, le dispositif de sonde de flux comprend une bobine radiale et une bobine tangentielle. Cela permet d'utiliser les deux signaux des deux bobines pour réaliser deux mesures par exemple simultanées qui seront traitées conjointement, ce qui renforce la fiabilité de la détection d'un défaut. Il est en effet possible que le signal traité de la bobine radiale ne révèle pas de défauts, alors que le signal traité de la bobine tangentielle traduira un défaut réel, et réciproquement. Comme expliqué précédemment il est préférable d'enregistrer le signal de sonde sur au moins 1,25 tours afin d'identifier clairement un tour complet pour le découpage du signal en tronçons polaires.

Enfin, un bon positionnement de la sonde est important pour la qualité des signaux traités. En particulier, la position de la bobine tangentielle dans l'entrefer doit se situer le plus possible au milieu de l'entrefer. Une sonde trop près du stator donne un signal de bobine tangentielle atténué, et une sonde trop près du rotor soit risque d'être cassée par le passage du rotor. En outre, la bobine tangentielle doit être positionnée de manière à ce qu'elle perçoive 100% de la composante tangentielle du flux d'entrefer. Pour cela, l'anneau formé par la bobine tangentielle doit former idéalement un angle de 90° avec les lignes du champ d'induction. Généralement, la canule de la sonde peut tourner autour de son axe et comporte un repère permettant l'orientation correcte de la bobine tangentielle, ainsi qu'un repère de limite d'introduction de la sonde dans l'entrefer. Concernant la bobine radiale, sa position est affectée uniquement par la distance de la sonde vis-à-vis du rotor, puisque idéalement la bobine est centrée sur l'axe de la canule qui lui-même est orienté radialement vers l'axe du rotor.

Le procédé de détection de défaut d'excentricité dynamique selon l'invention peut avantageusement être mis en oeuvre dans un appareillage d'acquisition et de traitement des signaux qui réalise également la détection de défauts de court-circuit dans les bobinages du rotor d'une machine électrique tournante, à partir des signaux d'une sonde de flux d'entrefer montée dans la machine. En effet, comme expliqué notamment dans le brevet américain US3506914, à partir du signal mesuré par une sonde de flux d'entrefer, le traitement de parties du signal pour une comparaison pôle à pôle permet de rechercher d'éventuels indices révélateurs de la présence d'un court-circuit. Etant donné que le procédé de détection selon la présente invention génère des signaux de différence entre des tronçons polaires, il est possible d'exploiter ces signaux de différence pour rechercher la présence d'un court-circuit.

On notera qu'en cas de mélange de défauts de court-circuit et d'excentricité dynamique, les défauts de courts-circuits ne sont généralement pas détectés. En effet, les écarts globaux sur les différences pôle à pôle dus à l'excentricité vont prendre le pas sur les écarts locaux dus au court-circuit. Ainsi il est possible qu'un défaut d'excentricité cache un court-circuit. La recherche de la présence d'un court-circuit pourra être effectuée dès lors que le procédé de détection selon l'invention a permis de conclure à l'absence de défaut d'excentricité dynamique.

## Revendications

1. Procédé de détection d'un défaut d'excentricité d'un rotor d'une machine électrique tournante telle qu'un alternateur, utilisant des mesures de flux électromagnétique réalisées par une sonde disposée dans un entrefer de la machine, et réalisant l'échantillonnage d'un signal de sonde (Vs) mesuré par la sonde sur au moins un tour du rotor, **caractérisé en ce qu'**il comprend les étapes suivantes :
- l'identification d'un tronçon entier de la mesure du signal de sonde (Vs) et son découpage en plusieurs tronçons polaires de même longueur chacun, ledit tronçon entier correspondant à un tour complet du rotor, la longueur d'un dit tronçon polaire étant déterminée comme la longueur dudit tronçon entier divisée par le nombre de pôles du rotor ;
- la génération d'au moins un signal de différence (Gi) représentatif de la différence point par point entre les mesures du signal de sonde (Vs) relatives à deux tronçons polaires ;
- le calcul d'un écart type (e) dudit signal de différence (Gi) ;
- pour chaque paire de deux tronçons polaires correspondant à un signal de différence (Gi), la détermination d'une valeur positive d'extremum (UG) prenant en compte au moins un extremum (U) des mesures du signal de sonde (Vs) sur les deux tronçons polaires ;
- le calcul d'un indicateur d'excentricité (Ei) pour chaque signal de différence (Gi), prenant en compte ledit écart type (e) du signal de différence ainsi que ladite valeur positive d'extremum (UG) ; et
- le signalement d'un défaut d'excentricité dynamique dès lors qu'au moins un dit indicateur d'excentricité (Ei) dépasse une valeur de seuil d'indicateur (S) prédéterminée.

2. Procédé de détection selon la revendication 1, dans lequel ladite valeur positive d'extremum (UG) du signal de sonde pour une paire de tronçons polaires est déterminée comme égale au maximum de la valeur absolue des mesures du signal de sonde (Vs) sur les deux tronçons polaires.

3. Procédé de détection selon la revendication 1 ou 2, dans lequel l'indicateur d'excentricité (Ei) est calculé comme le ratio entre ledit écart type (e) du signal de différence et ladite valeur positive d'extremum (UG).

4. Procédé de détection selon la revendication 3, dans lequel ladite valeur de seuil d'indicateur (S) est comprise entre 0,030 et 0,040, et est préférablement égale à 0, 035.

5. Procédé de détection selon l'une quelconque des revendications précédentes, dans lequel ledit signal de sonde (Vs) est enregistré sur un nombre de tours du rotor compris entre 1,25 et 2,5.

6. Procédé de détection selon l'une quelconque des revendications précédentes, dans lequel la fréquence d'échantillonnage du signal de sonde (Vs) est au moins égale à 50 KHz, et l'échantillonnage utilise un convertisseur analogique/numérique ayant une résolution d'au moins 12 bits.

7. Procédé de détection selon l'une quelconque des revendications précédentes, dans lequel si un signal de top-tour est disponible on identifie dans le signal de sonde (Vs) chaque instant correspondant à un top-tour ; et si un signal de top-tour n'est pas disponible, on construit ce signal (TT0, TT1) par auto-corrélation des mesures du signal de sonde (Vs) effectuées sur au moins 1,25 tours, en connaissance de la fréquence théorique du réseau et du nombre de paires de pôles de la machine électrique, le top-tour étant identifié par les maxima de corrélation.

8. Procédé de détection selon la revendication 7, dans lequel on identifie un dit tronçon entier du signal de sonde (Vs) comme la mesure du signal (Vs) sur une période (Tr) entre deux top-tours consécutifs (TT0, TT1), et on procède à un ré-échantillonnage du signal afin que chaque tronçon entier ait la même longueur en terme de nombre de points de mesure que la longueur théorique d'un tour sur la base de la fréquence théorique du réseau.

9. Procédé de détection selon l'une quelconque des revendications précédentes, dans lequel on génère un nombre Ns de signaux de différence (G1, G2,... ; GNs), Ns vérifiant la relation Ns = Np - 1 où Np est le nombre de pôles de la machine électrique, et dans lequel un défaut d'excentricité est signalé dès lors que l'indicateur d'excentricité (Ei) d'au moins un signal de différence (Gi) dépasse le seuil d'indicateur (S).

10. Procédé de détection selon l'une quelconque des revendications précédentes, dans lequel deux tronçons polaires consécutifs sont comparés entre eux pour générer un dit signal de différence (Gi).

## Patentansprüche

1. Detektionsverfahren zur Fehlererfassung in der Exzentrizität eines Rotors einer rotierenden elektrischen Maschine, beispielsweise eines Wechselstromgenerators, unter Verwendung von Messungen eines elektromagnetischen Flusses, die mit Hilfe einer in einem Luftspalt der Maschine angeordneten Sonde durchgeführt werden, und unter Durchführung des Abtastens eines von der Sonde gemessenen Sondensignals (Vs) über mindestens eine Umdrehung des Rotors, **dadurch gekennzeichnet, dass** es die folgenden Schritte aufweist:
- die Identifikation eines Gesamtabschnitts der Messung des Sondensignals (Vs) und seine Aufteilung in mehrere Polabschnitte mit jeweils gleicher Länge, wobei der Gesamtabschnitt einer vollen Umdrehung des Rotors entspricht und die Länge eines besagten Polabschnitts als die Länge des Gesamtabschnitts dividiert durch die Anzahl der Pole des Rotors festgelegt wird;
- die Erzeugung mindestens eines Differenzsignals (Gi), das die punktweise Differenz zwischen den Messungen des Sondensignals (Vs), die sich auf zwei Polabschnitte beziehen, repräsentiert;
- die Berechnung einer Standardabweichung (e) des Differenzsignals (Gi);
- für jedes Paar von zwei Polabschnitten, die einem Differenzsignal (Gi) entsprechen, die Bestimmung eines positiven Extremwerts (UG) unter Berücksichtigung mindestens eines Extrempunkts (U) der Messungen des Sondensignals (Vs) an den zwei Polabschnitten;
- die Berechnung eines Exzentrizitätsindikators (Ei) für jedes Differenzsignal (Gi) unter Berücksichtigung der Standardabweichung (e) des Differenzsignals sowie des positiven Extremwerts (UG); und
- die Signalisierung eines dynamischen Exzentrizitätsfehlers sobald mindestens ein besagter Exzentrizitätsindikator (Ei) einen vorgegebenen Indikator-Schwellenwert (S) überschreitet.

2. Detektionsverfahren nach Anspruch 1, in welchem der positive Extremwert (UG) des Sondensignals für ein Paar Polabschnitte als gleich dem Maximum des Absolutwerts der Messungen des Sondensignals (Vs) an den zwei Polabschnitten bestimmt wird.

3. Detektionsverfahren nach Anspruch 1 oder 2, in welchem der Exzentrizitätsindikator (Ei) als das Verhältnis zwischen der Standardabweichung (e) des Differenzsignals und dem positiven Extremwert (UG) berechnet wird.

4. Detektionsverfahren nach Anspruch 3, in welchem der Indikator-Schwellenwert (S) zwischen 0,030 und 0,040 ist und vorzugsweise gleich 0,035 ist.

5. Detektionsverfahren nach einem der vorstehenden Ansprüche, in welchem das Sondensignal (Vs) über eine Anzahl von 1,25 bis 2,5 Umdrehungen des Rotors erfasst wird.

6. Detektionsverfahren nach einem der vorstehenden Ansprüche, in welchem die Abtastfrequenz des Sondensignals (Vs) mindestens gleich 50KHz ist und das Abtasten einen Analog/Digital-Umsetzer, der eine Auflösung von mindestens 12 Bit hat, verwendet.

7. Detektionsverfahren nach einem der vorstehenden Ansprüche, in welchem in dem Fall, dass ein Umdrehungszeichen-Signal (Toptour-Signal) verfügbar ist, jeder Zeitpunkt, der einem Umdrehungszeichen entspricht, in dem Sondensignal (Vs) identifiziert wird; und in dem Fall, dass ein Umdrehungszeichen-Signal nicht verfügbar ist, dieses Signal (TT0, TT1) mittels einer Autokorrelation von Messwerten des Sondensignals (Vs), die über mindestens 1,25 Umdrehungen erfolgt, mit Kenntnis der theoretischen Frequenz des Netzes und der Anzahl von Polpaaren der elektrischen Maschine konstruiert wird, wobei das Umdrehungszeichen durch die Korrelationsmaxima identifiziert wird.

8. Detektionsverfahren nach Anspruch 7, in welchem ein besagter Gesamtabschnitt des Sondensignals (Vs) als die Messung des Signals (Vs) über eine Periode (Tr) zwischen zwei aufeinanderfolgenden Umdrehungszeichen (TT0, TT1) identifiziert wird und eine erneute Abtastung des Signals vorgenommen wird, so dass jeder Gesamtabschnitt die gleiche Länge in Hinblick auf Anzahl von Messpunkten hat wie die theoretische Länge einer Umdrehung auf Basis der theoretischen Frequenz des Netzes.

9. Detektionsverfahren nach einem der vorstehenden Ansprüche, in welchem eine Anzahl Ns von Differenzsignalen (G1, G2, ... GNs) erzeugt wird, wobei Ns die Beziehung Ns = Np - 1 erfüllt, wobei Np die Anzahl von Polen der elektrischen Maschine ist, und in welchem ein Exzentrizitätsfehler signalisiert wird, sobald der Exzentrizitätsindikator (Ei) mindestens eines Differenzsignals (Gi) den Indikator-Schwellenwert (S) überschreitet.

10. Detektionsverfahren nach einem der vorstehenden Ansprüche, in welchem zwei aufeinanderfolgende Polabschnitte miteinander verglichen werden, um ein besagtes Differenzsignals (Gi) zu erzeugen.

## Claims

1. Method for detecting a fault in the eccentricity of a rotor of a rotating electrical machine such as an alternator, using electromagnetic flow measurements carried out by a probe arranged in a gap of the machine, and carrying out the sampling of a probe signal (Vs) measured by the probe over at least one rotor revolution, **characterised in that** it comprises the following steps:
- the identifying of an entire section of measurement of the probe signal (Vs) and the division thereof into a plurality of polar sections of the same length, said entire section corresponding to a full revolution of the rotor, with the length of a said polar section being determined as the length of said entire section divided by the number poles of the rotor;
- the generating of at least one difference signal (Gi) representing the difference point by point between the measurements of the probe signal (Vs) relative to two polar sections;
- the calculating of a standard deviation (e) of said difference signal (Gi);
- for each pair of two polar sections corresponding to a difference signal (Gi), the determining of a positive value of extremum (UG) taking into account at least one extremum (U) of the measurements of the probe signal (Vs) on the two polar sections;
- the calculating of an eccentricity indicator (Ei) for each difference signal (Gi), taking into account said standard deviation (e) of the difference signal as well as said positive value of extremum (UG); and
- the signalling of a dynamic eccentricity fault as soon as at least one said eccentricity indicator (Ei) exceeds a pre-determined indicator threshold value (S).

2. Method for detecting according to claim 1, wherein said positive value of extremum (UG) of the probe signal for a pair of polar sections is determined as being equal to the maximum of the absolute value of the measurements of the probe signal (Vs) on the two polar sections.

3. Method for detecting according to claim 1 or 2, wherein the eccentricity indicator (Ei) is calculated as the ratio between said standard deviation (e) of the difference signal and said positive value of extremum (UG).

4. Method for detecting according to claim 3, wherein said indicator threshold value (S) is between 0.030 and 0.040, and is preferably equal to 0.035.

5. Method for detecting as claimed in any preceding claim, wherein said probe signal (Vs) is recorded over a number of revolutions of the rotor between 1.25 and 2.5.

6. Method for detecting as claimed in any preceding claim, wherein the sampling frequency of the probe signal (Vs) is at least equal to 50 KHz, and the sampling uses an analogue/digital convertor that has a resolution of at least 12 bits.

7. Method for detecting as claimed in any preceding claim, wherein if a revolution counter signal is available each instant corresponding to a revolution count is identified in the probe signal (Vs); and if a revolution counter signal is not available, this signal (TT0, TT1) is constructed through self-correlation of the measurements of the probe signal (Vs) carried out over at least 1.25 revolutions, knowing the theoretical frequency of the network and the number of pairs of poles of the electrical machine, with the revolution counter being identified by the correlation maxima.

8. Method for detecting according to claim 7, wherein said entire section of the probe signal (Vs) is identified as the measurement of the signal (Vs) over a period (Tr) between two consecutive revolution counters (TT0, TT1), and a re-sampling of the signal is carried out so that each entire section has the same length in terms of the number of measuring points as the theoretical length of one revolution based on the theoretical frequency of the network.

9. Method for detecting as claimed in any preceding claim, wherein a number Ns of difference signals (G1, G2, ...; GNs) is generated, with Ns satisfying the relationship Ns = Np - 1 where Np is the number of poles of the electrical machine, and wherein an eccentricity fault is signalled as soon as the eccentricity indicator (Ei) of at least one difference signal (Gi) exceeds the indicator threshold (S).

10. Method for detecting as claimed in any preceding claim, wherein two consecutive polar sections are compared with one another in order to generate a said difference signal (Gi).
